# EUROPÄISCHE PATENTSCHRIFT

(11) **EP 1 789 674 B1**
(45) Veröffentlichungstag und Bekanntmachung des Hinweises auf die Patenterteilung: **09.04.2008**
(21) Anmeldenummer: 05787281.4
(22) Anmeldetag: 06.09.2005
(51) Int. Cl.: F02M 51/06, F02M 61/16, F02M 63/00, H01L 41/053

(54) **HUBVORRICHTUNG UND EINSPRITZVENTIL**
LIFTING APPARATUS AND INJECTION VALVE
DISPOSITIF DE COURSE ET SOUPAPE D'INJECTION

(30) Priorität: 13.09.2004 DE 102004044153
(43) Veröffentlichungstag der Anmeldung: 30.05.2007
(73) Patentinhaber: VDO Automotive AG, 93055 Regensburg (DE)
(72) Erfinder: SCHÜRZ, Willibald, 93188 Pielenhofen (DE); SIMMET, Martin, 93077 Bad Abbach (DE)
(86) Internationale Anmeldenummer: PCT/EP2005/054376
(87) Internationale Veröffentlichungsnummer: WO 2006/029973

(56) Entgegenhaltungen:
- WO-A-98/25060
- WO-A-20/04104404
- DE-A1- 10 142 798
- DE-A1- 19 928 780
- US-A- 5 779 149
- US-A1- 2003 015 939
- US-B1- 6 313 568

## Beschreibung

Die Erfindung betrifft eine Hubvorrichtung mit einer Aktoreinheit und einem Widerlager. Ferner betrifft die Erfindung ein Einspritzventil, das die Hubvorrichtung und eine Düsennadel umfasst.

Einspritzventile, insbesondere für Brennkraftmaschinen in Kraftfahrzeugen, müssen hohe Präzisionsanforderungen erfüllen, um einen emissionsarmen und Ressourcen schonenden Betrieb der Brennkraftmaschine zu ermöglichen. Umfasst eine Hubvorrichtung des Einspritzventils beispielsweise einen Piezoaktor, dann sind die Präzisionsanforderungen entlang eines Kraftübertragungsweges besonders hoch, da Piezoaktoren prinzipbedingt nur einen kleinen Hub von beispielsweise einigen Mikrometern aufweisen. Reibung und elastische Bereiche entlang des Kraftübertragungsweges können den Hub verringern.

In der DE 101 42 798 A1 ist eine Lagerung für ein Piezoaktormodul in einem Einspritzventil offenbart. Eine Auflagefläche eines Aktorkopfes des Piezoaktormoduls ist als eine Kugelkalotte ausgeführt. Eine zugehörige Auflagefläche in einem Injektorkörper als Widerlager ist als ein Hohlkegel ausgebildet. Das Piezoaktormodul ist mittels einer Vorspannkraft gegen das widerlager gepresst.

In der US 6 313 568 B1 ist ein Piezoaktor und eine Ventilanordnung mit einer thermischen Ausdehnungskompensation offenbart. Der Piezoaktor ist durch eine Gehäuseanordnung umgeben. Die Gehäuseanordnung umfasst einen äußeren zylindrischen Gehäuseteil aus Stahl, der einen thermischen Ausdehnungskoeffizienten aufweist, der größer ist als der des Piezoaktors. Die Gehäuseanordnung umfasst ferner einen inneren zylindrischen -Gehäuseteil aus einer Si-Ni Keramik, der einen thermischen Ausdehnungskoeffizienten aufweist, der kleiner ist als der des Piezoaktors. Der innere und der äußere Gehäuseteil sind parallel zueinander angeordnet mit geeigneten Querschnittsflächen, so dass die Gehäuseanordnung einen effektiven thermischen Ausdehnungskoeffizienten aufweist, der dem des Piezoaktors entspricht.

In der DE 199 28 780 A1 ist ein Stellantrieb mit einem piezoelektrischen Aktor offenbart. Der piezoelektrische Aktor liegt mit seiner oberen Kontaktfläche an einer Kopfplatte und mit seiner unteren Kontaktfläche an einer Fußplatte auf. Der piezoelektrische Aktor ist mittels eines die Kopfplatte und die Fußplatte verbindendes Federelements druckvorspannbar. Ein Füllstoff ist vorgesehen, der mindestens eine Kavität zwischen dem Aktor und der Kopfplatte und/oder zwischen dem Aktor und der Fußplatte ausfüllt. Eine solche Kavität ergibt sich durch eine Balligkeit des Aktors an seiner oberen oder unteren Kontaktfläche, die durch einen Polarisierungsvorgang erzeugbar ist.

Der Erfindung liegt die Aufgabe zugrunde, eine Hubvorrichtung zu schaffen, bei der ein Hub zuverlässig übertragbar ist. Ferner ist die Aufgabe der Erfindung, ein Einspritzventil zu schaffen, bei dem ein Hub einer Düsennadel zuverlässig ist.

Die Aufgabe wird gelöst durch die Merkmale der unabhängigen Ansprüche. Vorteilhafte Weiterbildungen der Erfindung sind in den abhängigen Ansprüchen gekennzeichnet.

Gemäß eines ersten Aspekts zeichnet sich die Erfindung aus durch eine Hubvorrichtung, die ein Widerlager und eine Aktoreinheit umfasst. Das Widerlager weist eine erste Ausnehmung mit einer kegelförmigen Lagerfläche auf. Die Aktoreinheit umfasst einen Aktor, dessen axiale Ausdehnung abhängt von einem Stellsignal. Ferner hat die Aktoreinheit eine Schulter, die in einem dem Abtrieb abgewandten Bereich der Aktoreinheit ausgebildet ist und die eine gewölbte Oberfläche hat. Die Aktoreinheit stützt sich an der kegelförmigen Lagerfläche des Widerlagers mit ihrer gewölbten Oberfläche ab. Die Hubvorrichtung umfasst ferner eine Führungsbuchse mit einer durchgehenden Ausnehmung, in der die Aktoreinheit geführt ist. Die Aktoreinheit ist axial bewegbar in der Führungsbuchse angeordnet. Die Führungsbuchse besteht aus Sinterbronze mit einem Molybdändisulfidanteil.

Dies hat den Vorteil, dass sich die Aktoreinheit während der Montage oder auch während des Betriebs in ihrer Winkellage und rotatorisch in dem Widerlager so ausrichten kann, dass die Reibung dadurch verringert ist. Die gewölbte Oberfläche kann beispielsweise kugelförmig oder anders abgerundet ausgeführt sein. Die gewölbte Oberfläche der Aktoreinheit ist vorzugsweise so ausgeführt, dass sich durch das Abstützen gegen die kegelförmige Lagerfläche des Widerlagers ein linienförmiger Kontakt zwischen der gewölbten Oberfläche und der kegelförmigen Lagerfläche bildet. Dies hat den Vorteil, dass die Kraftübertragung sehr zuverlässig erfolgen kann und dass Hubverluste durch ein Einfedern des Kontakts durch eine Verformung der gewölbten Oberfläche oder der kegelförmigen Lagerfläche gering sind. Ein solcher Kontakt ermöglicht eine verlustarme Übertragung des Hubs. Die Verformung kann durch den Anpressdruck entstehen, der auf die in dem Kontakt aneinandergrenzenden Flächen einwirkt.

Die Führungsbuchse ist vorteilhafterweise so ausgebildet, dass eine Kontaktfläche zwischen der Führungsbuchse und der Aktoreinheit klein ist, so dass die Reibung gering ist. Durch das Ausrichten der Aktoreinheit in dem Widerlager kann die Aktoreinheit in der Führungsbuchse sehr reibungsarm geführt sein, da die Gefahr einer schrägen Ausrichtung der Aktoreinheit verringert ist. Neben dem Widerlager und der Führungsbuchse kann auf weitere Führungselemente für die Aktoreinheit verzichtet werden, so dass keine weitere Reibung entsteht. Dadurch können Hubverluste und Verschleiß vermieden oder verringert werden. Die Aktoreinheit ist vorzugsweise in einem Bereich ihres abtriebseitigen axialen Endes geführt. Dadurch ist der Abstand zwischen dem Widerlager und dem Bereich, in dem die Aktoreinheit geführt ist, besonders groß, so dass die reibungsarme Ausrichtung der Aktoreinheit besonders zuverlässig ist.

Ein weiterer Vorteil der Führungsbuchse ist, dass Sinterbronze einen ähnlichen Wärmeausdehnungskoeffizienten hat wie Stahl, aus dem beispielsweise der Bereich der Aktoreinheit bestehen kann, der in der Führungsbuchse geführt ist. Die Qualität der Führung der Aktoreinheit in der Führungsbuchse kann deshalb weitgehend unabhängig von der Temperatur sein. Der Molybdändisulfidanteil verringert die Reibung und damit den Verschleiß und verbessert so die Trockenlaufeigenschaften der Führungsbuchse. Eine solche Führungsbuchse kann einfach und billig hergestellt werden.

In einer vorteilhaften Ausgestaltung der Hubvorrichtung ist ein elastisches Element vorgesehen, das derart ausgebildet ist und derart mit der Aktoreinheit zusammenwirkt, dass die gewölbte Oberfläche mit der kegelförmigen Lagerfläche in Kontakt gehalten wird. Dies hat den Vorteil, dass durch ein Vorspannen des Kontakts zwischen der gewölbten Oberfläche und der kegelförmigen Lagerfläche mittels des elastischen Elements das Einfedern des Kontakts weiter verringert werden kann. Hubverluste können so vermindert sein. Das elastische Element erlaubt ein Ausrichten der Winkellage oder ein rotatorisches Ausrichten der Aktoreinheit in dem Widerlager. Das elastische Element verringert jedoch die Gefahr, dass die Aktoreinheit in dem Widerlager unbeabsichtigt verrutscht. Dies kann die Montage der Hubvorrichtung vereinfachen und Beschädigungen der Aktoreinheit oder des Widerlagers verhindern.

In einer weiteren vorteilhaften Ausgestaltung der Hubvorrichtung umfasst die Aktoreinheit ein Halselement, das sich durch eine zweite Ausnehmung erstreckt, die in dem Widerlager ausgebildet ist und dieses durchdringt. Das Halselement weist auf einer der Aktoreinheit abgewandten Seite des Widerlagers ein Kopfelement auf. Das elastische Element ist zwischen dem Kopfelement und dem Widerlager angeordnet. Dies hat den Vorteil, dass die Aktoreinheit an dem Widerlager aufgehängt ist und so die Montage vereinfachen kann. Ferner wirkt eine Kraft, die die gewölbte Oberfläche der Aktoreinheit und die kegelförmige Lagerfläche des widerlagers aufeinander presst, nicht entlang der Aktoreinheit, so dass diese Kraft bei der Auslegung der Aktoreinheit nicht berücksichtigt werden muss.

In einer weiteren vorteilhaften Ausgestaltung der Hubvorrichtung umfasst die Aktoreinheit ein Ausgleichselement, das in axialer Richtung mit dem Aktor gekoppelt ist. Ein solches Ausgleichselement kann insbesondere ausgebildet sein, um temperaturabhängige axiale Längenänderungen auszugleichen. Piezoaktoren besitzen beispielsweise einen anderen wärmeausdehnungskoeffizienten als beispielsweise Stahl, so dass die unterschiedlichen temperaturabhängigen axialen Längenausdehnungen, beispielsweise des Piezoaktors und eines Stahlgehäuses, kompensiert werden können. Dies ermöglicht einen von der Temperatur unabhängigen Hub der Hubvorrichtung.

In einer weiteren vorteilhaften Ausgestaltung der Hubvorrichtung sind das Ausgleichselement und der Aktor formschlüssig miteinander verbunden. Eine solche formschlüssige Verbindung kann Hubverluste durch das Einfedern des Kontakts zwischen dem Ausgleichselement und dem Aktor verringern, so dass der Kontakt sehr steif ist. Ferner können das Ausgleichselement und der Aktor präzise zueinander ausgerichtet werden, beispielsweise auf eine gemeinsame Achse. Dadurch ist es möglich, Verluste durch Reibung zu vermeiden, die beispielsweise durch eine schräge Führung der Aktoreinheit verursacht werden können.

In diesem Zusammenhang ist es vorteilhaft, wenn das Ausgleichselement und der Aktor durch Verpressen miteinander verbunden sind. Eine solche Verbindung ist sehr robust und ermöglicht eine sehr präzise Ausrichtung des Ausgleichselements und des Aktors zueinander. Ferner ist diese Verbindung sehr steif, sodass Hubverluste durch das Einfedern des Kontakts zwischen dem Aktor und dem Ausgleichselement vermieden werden können.

Gemäß eines zweiten Aspekts zeichnet sich die Erfindung aus durch ein Einspritzventil, das eine Hubvorrichtung und eine Düsennadel umfasst. Die Düsennadel ist abtriebseitig der Hubvorrichtung mit dieser gekoppelt und unterbindet in einer Schließposition einen Fluidfluss durch eine Einspritzdüse und gibt diesen ansonsten frei. Ein solches Einspritzventil hat den Vorteil, dass der Hub der Düsennadel sehr zuverlässig ist, so dass ein einzuspritzendes Fluid zuverlässig dosierbar ist.

Ausführungsbeispiele der Erfindung sind im Folgenden anhand der schematischen Zeichnungen erläutert. Es zeigen:
Figur 1 ein Einspritzventil,
Figur 2 eine Hubvorrichtung und
Figur 3 einen Ausschnitt aus der Hubvorrichtung gemäß Figur 2.

Elemente gleicher Konstruktion oder Funktion sind figurenübergreifend mit den gleichen Bezugszeichen versehen.

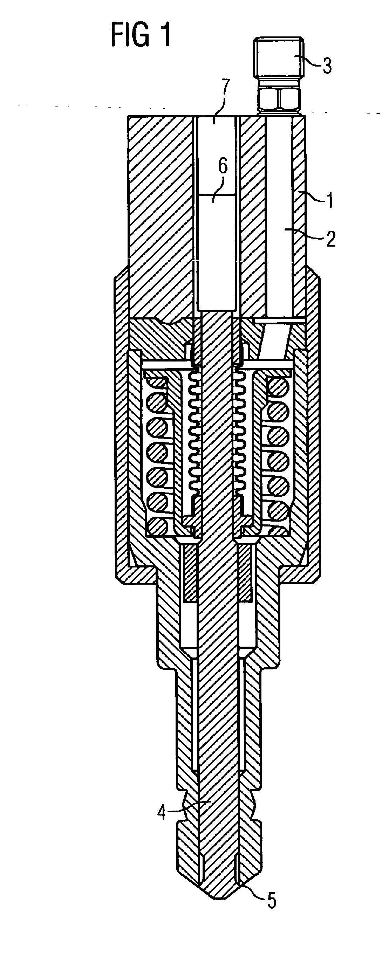

Figur 1 zeigt ein Einspritzventil, insbesondere für Brennkraftmaschinen in Kraftfahrzeugen. Das Einspritzventil hat ein Injektorgehäuse 1, in dem eine Bohrung 2 ausgebildet ist, und einen Anschluss 3, der mit der Bohrung 2 gekoppelt ist und durch den dem Einspritzventil Kraftstoff zugeführt werden kann. Das Einspritzventil umfasst ferner eine Düsennadel 4, die in einer Schließposition eine Einspritzdüse 5 verschließt und anderenfalls einen Kraftstofffluss durch die Einspritzdüse 5 zulässt. Das Einspritzventil umfasst ferner eine Hubvorrichtung mit einer Aktoreinheit, die einen Aktor 6 und ein Ausgleichselement 7 umfasst, die in axialer Richtung miteinander gekoppelt sind. Der Aktor 6 ist beispielsweise ein Piezoaktor. Der Hub der Hubvorrichtung ist abhängig von der axialen Ausdehnung des Aktors 6, die abhängig ist von einem Stellsignal. Die Hubvorrichtung ist gekoppelt mit der Düsennadel 4 und wirkt derart mit der Düsennadel 4 zusammen, dass der Hub der Hubvorrichtung auf die Düsennadel 4 übertragen wird und dass die Düsennadel 4 so in ihre Schließposition oder in eine Offenposition bewegt wird.

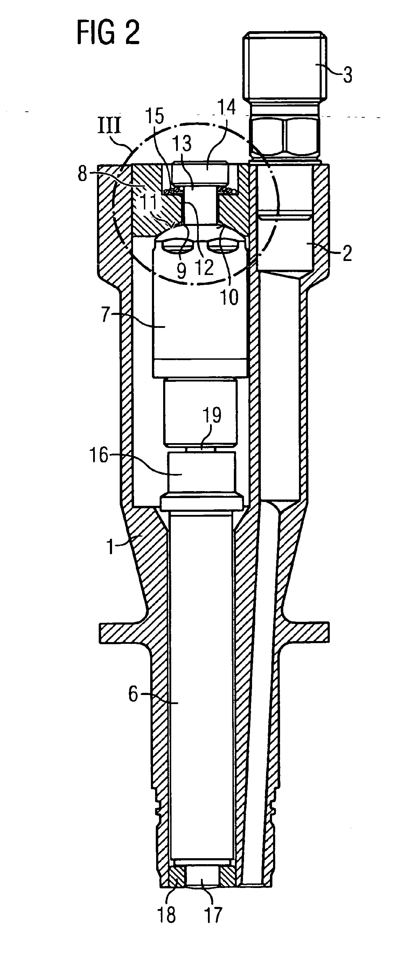

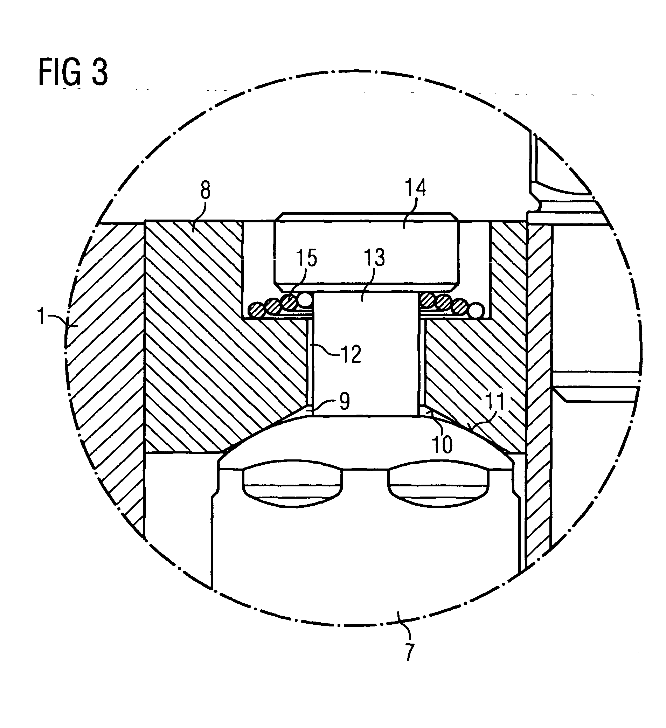

Figur 2 zeigt eine Hubvorrichtung und Figur 3 zeigt einen vergrößerten Ausschnitt aus der in Figur 2 dargestellten Hubvorrichtung. Die Hubvorrichtung ist in dem Injektorgehäuse 1 angeordnet und umfasst ein Widerlager 8, das eine erste Ausnehmung 9 hat, in der eine kegelförmige Lagerfläche 10 ausgebildet ist. Das Ausgleichselement 7 hat in einem Bereich, der einem Abtrieb der Aktoreinheit abgewandt ist, eine gewölbte Oberfläche 11, mit der sich das Ausgleichselement 7 an der kegelförmigen Lagerfläche 10 des Widerlagers 8 abstützt. Das Ausgleichselement 7 ist in dem Widerlager 8 rotatorisch und in seiner Winkellage bewegbar angeordnet, d.h. das Ausgleichelement 7 ist um seine Längsachse in dem Widerlager 8 rotierbar und das Ausgleichselement 7 ist in dem Widerlager 8 so bewegbar, dass seine Längsachse gegenüber der Kegelachse der kegelförmigen Lagerfläche 10 schwenkbar ist, also der Winkel zwischen der Längsachse des Ausgleichselements 7 und der Kegelachse veränderbar ist. Die gewölbte Oberfläche 11 kann beispielsweise sphärisch oder kugelförmig ausgebildet sein oder so abgerundet sein, dass ein Kontakt zwischen der gewölbten Oberfläche 11 und der kegelförmigen Lagerfläche 10 linienförmig ist. Das Ausgleichselement 7 ist beispielsweise ein hydraulischer Temperaturkompensator.

Das Widerlager 8 weist eine zweite Ausnehmung 12 auf, durch die sich ein stangenförmiges Halselement 13 erstreckt, das mit dem Ausgleichselement 7 gekoppelt ist. Das Halselement 13 ist vorzugsweise in radialer Richtung beabstandet zu einer Wandung der zweiten Ausnehmung 12 angeordnet. Dies ermöglicht das Ausrichten des Ausgleichselements 7 in dem Widerlager 8 bezüglich seiner Winkellage. Auf einer dem Ausgleichselement 7 abgewandten Seite des Widerlagers 8 ist an einem axialen Ende des Halselements 13 ein Kopfelement 14 angeordnet. Das Kopfelement 14 ist beispielsweise eine Mutter, die auf das axiale Ende des Halselements 13 aufgeschraubt ist, oder ein Ring, der auf das axiale Ende des Halselements 13 aufgepresst ist. Zwischen dem Kopfelement -14 und dem Widerlager 8 ist ein elastisches Element 15 in Form einer Kegelfeder angeordnet, das den Kontakt zwischen der gewölbten Oberfläche 11 und der kegelförmigen Lagerfläche 10 vorspannt. Dadurch kann die Gefahr eines Einfederns des Kontakts verringert und so ein Hubverlust vermieden werden. Jedoch erlaubt eine elastische Aufhängung der Aktoreinheit an dem Widerlager 8 eine Ausrichtung der Winkellage und eine rotatorische Ausrichtung der Aktoreinheit in dem Widerlager 8.

Der Aktor 6 umfasst eine Aktorkappe 16 und eine abtriebseitige Kappe 17. Die Aktorkappe 16 ist an einem dem Abtrieb abgewandten axialen Ende des Aktors 6 angeordnet. Der Aktor 6 ist vorzugsweise in einem Bereich der abtriebseitigen Kappe 17 in einer Führungsbuchse 18 axial bewegbar geführt.

Vorzugsweise sind der Aktor 6 und das Ausgleichselement 7 formschlüssig miteinander verbunden. Dazu ist beispielsweise eine Koppelstange 19 vorgesehen, die einstückig mit dem Ausgleichselement 7 oder der Aktorkappe 16 ausgebildet sein kann oder in das Ausgleichselement 7 oder die Aktorkappe 16 eingepresst sein kann. Ebenso können der Aktor 6 und das Ausgleichselement 7 beispielsweise durch Schrauben, Schweißen oder Kleben miteinander verbunden sein. Insbesondere ist eine Verbindung vorteilhaft, die den Aktor 6 und das Ausgleichselement 7 zuverlässig und verzugsarm zueinander fixiert, beispielsweise so, dass der Aktor 6 und das Ausgleichselement 7 eine gemeinsame Längsachse haben. Dadurch kann verhindert werden, dass unerwünschte Reibung und Hubverluste entstehen, indem beispielsweise das Ausgleichselement 7 oder der Aktor 6 mit der Wandung des Injektorkörpers 1 in Berührung kommen oder der Aktor 6 schräg in der Führungsbuchse 18 geführt ist.

Die Führungsbuchse 18 ist vorzugsweise aus einem Material hergestellt, das eine reibungsarme Führung des Aktors 6 ermöglicht, insbesondere auch über einen während des Betriebs auftretenden Temperaturbereich. Ist beispielsweise die abtriebseitige Kappe 17 aus Stahl hergestellt, dann ist es vorteilhaft, die Führungsbuchse 18 beispielsweise aus Sinterbronze herzustellen, da Sinterbronze einen ähnlich großen Wärmeausdehnungskoeffizienten aufweist wie Stahl. Ferner ist es vorteilhaft, der Sinterbronze Molybdändisulfid zuzusetzen, das die Eigenschaften der Führungsbuchse 18 bezüglich Reibung und Verschleiß verbessern kann. Die Führungsbuchse 18 kann jedoch auch aus einem anderen Material hergestellt sein, beispielsweise aus Teflon.

Das Halselement 13 und das Kopfelement 14 können einstückig, beispielsweise als eine Schraube, ausgebildet sein und in das Ausgleichselement 7 eingeschraubt sein. Ebenso kann das Halselement 13 beispielsweise durch Kleben, Schweißen oder durch Einpressen mit dem Ausgleichselement 7 verbunden sein. In dem Halselement 13 kann ein Gewinde oder eine Nut ausgebildet sein. Anstelle des Kopfelements 14 kann ebenso ein Federring oder eine Federscheibe auf das Halselement 13 aufgepresst oder in der Nut angeordnet sein. Alternativ kann auch beispielsweise ein Sicherungsring oder eine Sicherungsscheibe für Achsen oder Wellen vorgesehen sein. Alternativ zu der Kegelfeder, die das elastische Element 15 bildet, kann ebenso eine anders ausgebildete Feder oder ein Federring oder eine Federscheibe vorgesehen sein.

Der Aktor 6 und das Ausgleichselement 7 können auch anders in der Aktoreinheit angeordnet sein, z.B. in axialer Richtung miteinander vertauscht. So kann beispielsweise die gewölbte Oberfläche 11 auch an dem Aktor 6, z.B. an der Aktorkappe 16, ausgebildet sein und sich in der kegelförmigen Lagerfläche 10 des Widerlagers 8 abstützen. Entsprechend ist dann das Halselement 13 mit dem Aktor 6 gekoppelt und das Ausgleichselement 7 kann in der Führungsbuchse 18 geführt sein.

In der Hubvorrichtung sind nur wenige und kleine Kontaktflächen vorgesehen, so dass die Hubvorrichtung reibungsarm und verschleißarm betrieben werden kann. Ferner hat die Hubvorrichtung entlang eines Kraftübertragungsweges nur wenige Kontaktstellen, an denen ein Hubverlust durch das Einfedern des Kontakts entstehen kann. Die selbstjustierende Ausrichtung der Aktoreinheit in der Hubvorrichtung ermöglicht einen reibungsarmen und verschleißarmen Betrieb. Das Einspritzventil mit dieser Hubvorrichtung kann einen dauerhaft zuverlässigen Hub der Düsennadel 4 aufweisen, so dass Kraftstoff zuverlässig in einen Verbrennungsraum einer Brennkraftmaschine eingespritzt werden kann.

Die Hubvorrichtung kann nicht nur in Einspritzventilen für Brennkraftmaschinen eingesetzt werden, sondern beispielsweise auch in anderen Ventilen oder in anderen Vorrichtungen, in denen ein Hub zuverlässig übertragen werden soll.

## Patentansprüche

1. Hubvorrichtung, die umfasst
- ein Widerlager (8), das eine erste Ausnehmung (9) mit einer kegelförmigen Lagerfläche (10) aufweist, und
- eine Aktoreinheit, die einen Aktor (6) umfasst, dessen axiale Ausdehnung abhängt von einem Stellsignal, und die eine Schulter hat, die in einem dem Abtrieb abgewandten Bereich der Aktoreinheit ausgebildet ist und die eine gewölbte Oberfläche (11) hat und die sich an der kegelförmigen Lagerfläche (10) des Widerlagers (8) mit ihrer gewölbten Oberfläche (11) abstützt,
**dadurch gekennzeichnet, dass** die Hubvorrichtung eine Führungsbuchse (18) mit einer durchgehenden Ausnehmung aufweist, in der die Aktoreinheit geführt ist und in der die Aktoreinheit axial bewegbar angeordnet ist, und die Führungsbuchse (18) aus Sinterbronze mit einem Molybdändisulfidanteil besteht.

2. Hubvorrichtung nach Anspruch 1, die ein elastisches Element (15) aufweist, das derart ausgebildet ist und derart mit der Aktoreinheit zusammenwirkt, dass die gewölbte Oberfläche (11) mit der kegelförmigen Lagerfläche (10) in Kontakt gehalten wird.

3. Hubvorrichtung nach Anspruch 2, bei der die Aktoreinheit ein Halselement (13) umfasst, das sich durch eine zweite Ausnehmung (12) erstreckt, die in dem Widerlager (8) ausgebildet ist und dieses durchdringt, und das an einer der Aktoreinheit abgewandten Seite des Widerlagers (8) ein Kopfelement (14) hat und das elastische Element (15) zwischen dem Kopfelement (14) und dem Widerlager (8) angeordnet ist.

4. Hubvorrichtung nach einem der vorstehenden Ansprüche, bei der die Aktoreinheit ein Ausgleichselement (7) umfasst, das in axialer Richtung mit dem Aktor (6) gekoppelt ist.

5. Hubvorrichtung nach Anspruch 4, bei der das Ausgleichselement (7) und der Aktor (6) formschlüssig miteinander verbunden sind.

6. Hubvorrichtung nach Anspruch 5, bei der das Ausgleichselement (7) und der Aktor (6) durch Verpressen miteinander verbunden sind.

7. Einspritzventil, das umfasst
- eine Hubvorrichtung nach einem der Ansprüche 1 bis 6, und
- eine Düsennadel (4), die abtriebseitig der Hubvorrichtung mit dieser gekoppelt ist und die in einer Schließposition einen Fluidfluss durch eine Einspritzdüse (5) unterbindet und diesen ansonsten freigibt.

## Claims

1. Lifting apparatus, consisting of:
- a counter bearing (8) comprising a first recess (9) having a conical bearing surface (10), and
- an actuator unit, comprising an actuator (6), the axial extension of which is dependent on an actuating signal, and which has a shoulder formed in an area of the actuator unit facing away from the output, and has a domed surface (11), and the domed surface (11) of the actuator unit rests upon the conical bearing surface (10) of the counter bearing (8),
**characterized in that**
the lifting apparatus has a guide bush (18) with a continuous recess, in which the actuator unit is guided and in which the actuator unit is arranged in such a way that it can be moved axially. The guide bush (18) is made of sintered bronze with molybdenum sulphide.

2. Lifting apparatus according to claim 1, which has an elastic element (15) designed in such a way and working together with the actuator unit in such a way that the domed surface (11) is in contact with the conical bearing surface (10).

3. Lifting apparatus according to claim 2, in which the actuator unit comprises a neck element (13) that stretches through a second recess, (12) which is formed in the counter bearing (8) and penetrates it, and the neck element is provided with a head element (14) on the side of the counter bearing (8) facing away from the actuator unit, and the elastic element (15) is arranged between the head element (14) and the counter bearing (8).

4. Lifting apparatus according to one of the preceding claims, in which the actuator unit comprises a compensating element (7) which is coupled to the actuator (6) in the axial direction.

5. Lifting apparatus according to claim 4, in which the compensating element (7) and the actuator (6) are connected positively to each other.

6. Lifting apparatus according to claim 5, in which the compensating element (7) and the actuator (6) are connected to each other by pressing.

7. Injection valve, comprising
- a lifting apparatus according to one of claims 1 to 6, and
- an nozzle needle (4) coupled to the lifting apparatus on the output side, which prevents the flow of liquid through the injector nozzle (5) when closed and otherwise releases it.

## Revendications

1. Dispositif à débattement comportant :
- une butée (8) qui comporte un premier évidement (9) avec une surface d'appui (10) conique, et
- une unité d'actionnement, qui comporte un actionneur (6), dont la dilatation axiale dépend d'un signal de réglage, et qui comporte un épaulement, qui est formé dans une zone, opposée à la sortie, de l'unité d'actionnement et qui comporte une surface (11) bombée et qui, avec sa surface (11) bombée, prend appui sur la surface d'appui (10) conique de la butée (8),
**caractérisé en ce que** le dispositif à débattement comporte une douille de guidage (18) avec un évidement débouchant, dans lequel est guidée l'unité d'actionnement et dans lequel l'unité d'actionnement est agencée de manière mobile dans le sens axial, et la douille de guidage (18) est réalisée en bronze fritté contenant du bisulfure de molybdène.

2. Dispositif à débattement selon la revendication 1, qui comporte un élément élastique (15), qui est réalisé et qui coopère avec l'unité d'actionnement de telle sorte que la surface (11) bombée est maintenue en contact avec la surface d'appui (10) conique.

3. Dispositif à débattement selon la revendication 2, dans lequel l'unité d'actionnement comporte un élément en forme de tige (13), qui passe à travers un deuxième évidement (12), qui est réalisé dans la butée (8) et traverse celle-ci, et qui, comporte un élément en forme de tête (14) sur le côté de la butée (8), opposé à l'unité d'actionnement, et l'élément élastique (15) est agencé entre l'élément en forme de tête (14) et la butée (8).

4. Dispositif à débattement selon l'une quelconque des revendications précédentes, dans lequel l'unité d'actionnement comporte un élément de compensation (7), qui est couplé à l'actionneur (6) dans le sens axial.

5. Dispositif à débattement selon la revendication 4, dans lequel l'élément de compensation (7) et l'actionneur (6) sont assemblés l'un à l'autre par conjugaison de forme.

6. Dispositif à débattement selon la revendication 5, dans lequel l'élément de compensation (7) et l'actionneur (6) sont assemblés l'un à l'autre par compression.

7. Soupape d'injection qui comporte :
- un dispositif à débattement selon l'une quelconque des revendications 1 à 6, et
- une aiguille d'injecteur (4), qui est couplée au dispositif à débattement du côté sortie de celui-ci et qui, dans une position de fermeture, empêche un passage du fluide à travers un injecteur (5) et, dans le cas contraire, libère ce passage.
